(19) **Europäisches Patentamt**
European Patent Office
Office européen des brevets

(11) **EP 1 529 342 B1**

(12) **EUROPÄISCHE PATENTSCHRIFT**

(45) Veröffentlichungstag und Bekanntmachung des Hinweises auf die Patenterteilung:
**24.10.2007 Patentblatt 2007/43**

(21) Anmeldenummer: **03724892.9**

(22) Anmeldetag: **12.05.2003**

(51) Int Cl.:
*H03K 5/1252* (2006.01)  *H04L 1/00* (2006.01)

(86) Internationale Anmeldenummer:
**PCT/DE2003/001521**

(87) Internationale Veröffentlichungsnummer:
**WO 2004/017519 (26.02.2004 Gazette 2004/09)**

(54) **VERFAHREN ZUR STÖRBEFREIUNG VON MESSIGNALEN**

METHOD FOR THE FILTERING OF NOISE FROM MEASURED SIGNALS

PROCEDE DE DEPARASITAGE DE SIGNAUX DE MESURE

(84) Benannte Vertragsstaaten:
**DE FR GB IT**

(30) Priorität: **25.07.2002 DE 10233835**

(43) Veröffentlichungstag der Anmeldung:
**11.05.2005 Patentblatt 2005/19**

(73) Patentinhaber: **ROBERT BOSCH GMBH**
**70442 Stuttgart (DE)**

(72) Erfinder:
• **IRION, Hans**
**71364 Winnenden (DE)**
• **HAASE, Bjoern**
**70182 Stuttgart (DE)**

(56) Entgegenhaltungen:
**EP-A- 0 583 966**   **WO-A-02/054660**
**DD-A- 233 188**   **DE-A- 3 905 735**
**US-A- 6 082 366**

**Beschreibung**

Die Erfindung bezieht sich auf ein Verfahren zur Störbefreiung von Messsignalen, die von gepulsten Störsignalen mit einem bekannten oder bestimmbaren Störpulsabstand verfälscht sind, wobei die Erfassungsdauer eines Einzelmesswertes kleiner ist als eine Störpulsdauer und mehrere Einzelmesswerte in frei wählbaren Zeitabständen des Messsignals erfasst werden.

Stand der Technik

Der üblicherweise bei Vorliegen externer Störer eingeschlagene Weg, die betroffenen Leitungen, Sensoren oder Schaltungsteile abzuschirmen, ist häufig mit erheblichen Kosten verbunden und gelingt insbesondere bei magnetischer Einkoppelung oft nur unzureichend. Häufig lässt sich auch prinzipbedingt eine Abschirmung nicht realisieren. Dies ist beispielsweise der Fall bei kapazitiv arbeitenden Ortungsgeräten, wie sie z.B. zum Auffinden von dielektrischen Einschlüssen in Bauwerkstoffen eingesetzt werden (gelegentlich auch Balkensucher genannt). Hier können die Platten des Messkondensators des Sensors prinzipbedingt nicht abgeschirmt werden. Derartige besonders störanfällige Ortungsgeräte sind beispielsweise in der WO 02/14847 A1 und der DE 199 15 016 C2 beschrieben.
Zu den ebenfalls besonders störanfälligen Geräten gehören Radargeräte, Funkgeräte und andere Anwendungen, bei denen prinzipbedingt Hochfrequenzstörungen nicht abgeschirmt werden können.
Ein weiteres, häufig eingesetztes Verfahren, welches eine Störreduzierung durch Mittelung realisiert, führt oft zu unzumutbar langen Messzeiten. Die Störamplitude sinkt nur mit der Quadratwurzel der Messzeit.
Liegt eine genutzte Arbeitsfrequenz des Messsystems im GHz-Bereich, beispielsweise zwischen 1 und 3 GHz, so gibt es ein erhebliches Störpotential durch verschiedene Mobilfunkanwendungen, z.B. durch Anwendungen nach den DECT, GSM und Bluetooth=Standards. Derartige, nach dem sogenannten TDMA-Verfahren arbeitende Störquellen senden in periodischen Intervallen (Frames) immer nur für kurze Zeit (Timeslots) impulsartige Störsignale aus, die zu einer periodischen Störung des empfangenen Messsignals führen.
Oft werden jedoch auch Messaufbauten beeinflusst, welche nicht im GHz-Bereich arbeiten. So führen beispielsweise nichtlineare Kennlinien elektronischen Bauelementen in Messschaltungen in Kombination beispielsweise mit hohen Sendeleistungen von Mobiltelefonen auch zu Störungen in Schaltungen, welche eigentlich nur im Niederfrequenzbereich arbeiten. Das erfindungsgemäße Verfahren führt auch in diesen Fällen zum Erfolg.
Generell sind die Auswirkungen gepulster Störer in vielfältigen Arten von Messaufbauten zu beobachten, in denen schwache elektrische Messgrößen erfasst werden. Die Verfälschung der Messsignale kann insbesondere durch elektromagnetische Einstreuung verursacht werden, welche beispielsweise in Messsensoren und Auswerteschaltungen erfolgen kann.
Die DE 39 05 735 A1 beschreibt ein Verfahren zur Auswertung eines zeitlich veränderlichen und periodisch pulsierenden Eingangssignals, bei dem aus dem zeitlichen Mittelwert des Eingangssignals ein pulsationsfreies Ersatzsignal erzeugt wird. Dabei wird im Bereich der instationären Signalübergänge das Ersatzsignal aus dem Eingangssignal selbst gebildet, wodurch sich ein verzögerungsfreier Betriebsablauf erzielen lässt. Vorzugsweise erfolgt die Mittelwertbildung bei dem Verfahren der D1 durch Abtasten sowie Speichern und Verarbeiten einer Mindestanzahl aller Signalproben des Eingangssignals, die zu einem bestimmten Zeitpunkt während einer oder mehrerer Pulsationsperioden angefallen sind.
Darüber hinaus offenbart die DE 39 05 735 A1 eine zur Durchführung des Verfahrens dienende Einrichtung, die einen Mittelwertbilder, vorzugsweise einen solchen mit Taktung und Abtastung von Signalproben, einen Vergleicher zum Umschalten der Auswertung in den Signalübergangsbereichen und einem hiervon gesteuerten Umschalter besitzt.
Der Erfindung liegt die Aufgabe zugrunde, ein Verfahren der eingangs genannten Art bereitzustellen, mit dem ein durch ein pulsartiges periodisches Störsignal gestörtes Messsignal möglichst wirkungsvoll von der Störung befreit wird.

Vorteile der Erfindung

Diese Aufgabe wird mit den Merkmalen des Anspruchs 1 gelöst. Hiernach ist vorgesehen, dass mindestens drei aufeinander folgende Einzelmesswerte mit Zeitabständen erfasst werden, die sich von dem Störpulsabstand unterscheiden, und dass mit den mindestens drei Einzelmesswerten eine störbefreite Messgröße ermittelt wird.
Mit diesen Merkmalen wird erreicht, dass gestörte Einzelmesswerte unterdrückt und für die Herleitung der Messgröße zumindest im Wesentlichen nur ungestörte Einzelmesswerte herangezogen werden, so dass eine von der impulsartig sendenden Störquelle unbeeinträchtigte Messgröße gewonnen wird. Die erfindungsgemäße Störbefreiung gelingt dabei ohne Einsatz von Abschirmungsmaßnahmen, erfordert keine langen Messzeiten und gestattet für eine weite Klasse potentieller Störer eine vollständige Störbefreiung.
Für die Durchführung der Störbeseitigung ist vorteilhaft, wenn die Zeitabstände der Einzelmessungen, aus denen sich das störbefreite Signal ermitteln lässt, konstant sind und somit die Einzelmessungen mit einer gleichbleibenden Periodendauer aufgenommen werden.

Eine Störbeseitigung mit besonders wenig Aufwand wird dann erzielt, wenn die Zeitabstände der Einzelmessungen so gewählt werden, dass von drei aufeinander folgenden Messwerten maximal einer fehlerbehaftet ist. Der einzelne gestörte Messwert wird sich im Allgemeinen stark von den zwei ungestörten Messwerten unterscheiden. Bei Berechnung des Medians über drei aufeinander folgende Messwerte erhält man in diesem Fall sicher einen der beiden ungestörten Messwerte. Das Verfahren der Medianbestimmung ist dabei nicht auf die Verwendung von drei Einzelmesswerten beschränkt, sondern lässt sich unmittelbar auf mehr als drei Einzelmessungen erweitern.

Eine weitere vorteilhafte Vorgehensweise besteht darin, dass festgestellt wird, welcher oder welche Einzelmesswert(e) sich von den anderen, mehr als die Hälfte darstellenden Einzelmesswerten am meisten unterscheidet/ unterscheiden, und dass die Messgröße mit dem Mittelwert der anderen Einzelmesswerte bestimmt wird.

Eine Störung durch verschiedene Störquellen mit unterschiedlicher Störpulsdauer und/oder unterschiedlichem Störpulsabstand kann auf einfache Weise dadurch beseitigt werden, dass die Periodendauer so gewählt ist, dass das Messsignal simultan von mindestens zwei verschiedenen Störsignalen mit unterschiedlichem Störpulsabstand befreit wird.

Beispielsweise um den Betrieb einer Störquelle vor einer Durchführung der Störbeseitigung zu erkennen, kann vorteilhaft vorgesehen sein, dass zum Unterscheiden verfälschter und unverfälschter Messsignale die Messsignale kontinuierlich erfasst werden und die erste oder eine höhere Ableitung der Amplituden des Messsignals über der Zeit berechnet wird. Alternativ kann die erste oder eine höhere Ableitung einer Funktion der Amplitude des Messsignals zur Bewertung herangezogen werden, beispielsweise deren Betragsquadrat.

Zeichnung

Die Erfindung wird nachfolgend anhand eines Ausführungsbeispiels unter Bezugnahme auf die Zeichnungen näher erläutert. Es zeigen:

Fig. 1a, b, c   eine schematische Darstellung zur Ermittlung eines Spannungssignals durch Abtastung eines anliegenden Messsignals und

Fig. 2a, b, c   eine schematische Darstellung zum Gewinnen von Erfassungswerten und Herleiten einer störbefreiten Messgröße.

Ausführungsbeispiel

Wie vorstehend bereits diskutiert, sind insbesondere solche Anwendungen von Funkstörungen betroffen, bei welchen prinzipbedingt eine ausreichende Abschirmung nicht realisiert werden kann. Dies ist beispielsweise der Fall bei Ortungsgeräten zum Auffinden verborgener Objekte in Bauwerkstoffen. Als Sensor wird dort ein Plattenkondensator eingesetzt, dessen Streufeld in den Bauwerkstoff eingreift. Veränderungen des dielektrischen Mediums im Bereich des Streufeldes des Sensorkondensators verursachen eine Änderung der Kapazität, welche sich elektrisch vermessen lässt. In vorteilhafter Weise wird diese Kapazitätsänderung so vermessen, dass ein elektrischer Schwingkreis aufgebaut wird, welcher den Sensorkondensator enthält. Aus der Abklingkurve nach einer Anregung des Schwingkreises lassen sich dann Rückschlüsse auf die Kapazität des Sensorkondensators und somit auf im Bauwerkstoff verborgene Objekte ziehen.

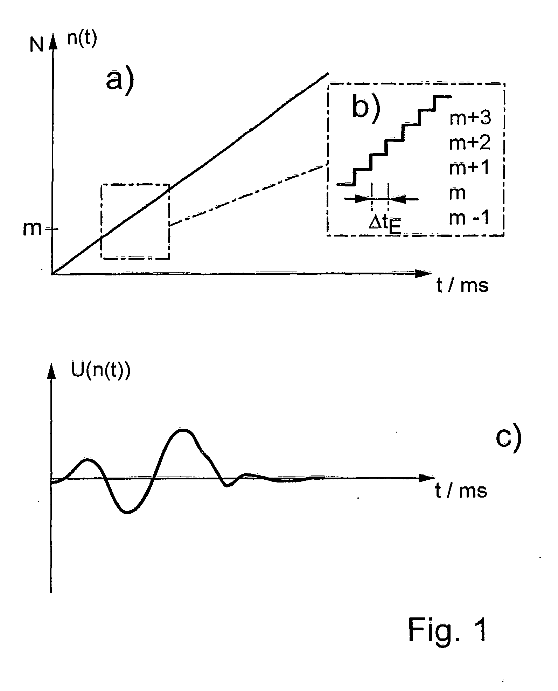

Da die Kapazität geeigneter Sensorkondensatoren sehr gering ist, erhält man in der Praxis hohe Eigenfrequenzen, weiche durchaus in der Größenordnung von 1-3 GHz liegen können. Die vermessenen Sensorsignale sind somit als eingangsseitige Messsignale in Gefahr, durch Mobilfunkanwendungen gestört zu werden. Wie anhand Fig. 1 gezeigt, kann das Abklingverhalten eines Schwingkreises im GHz-Bereich durch synchrone Abtastung vermessen werden, bei der beispielsweise eine am Messkondensator anliegende Spannung $U_{HF}(t)$ zu verschiedenen Zeitpunkten $t_{HF}(n)$

$$t_{HF}(n) = n \times \Delta t_{HF}$$

mit jeweiligem Zeitabstand $\Delta T_{HF}$ und zugehörigem Zeitindex n nach Anregung des Schwingkreises zum Zeitpunkt $t_{HF}$ (O) = 0 ermittelt wird. Der Zeitabstand bzw. die Schrittweite $\Delta t_{HF}$ liegt bei Oszillationsfrequenzen im Bereich von 2 GHz beispielsweise vorteilhaft in der Größenordnung von 50 ps. (Hierbei beachtlich ist die Unterscheidung von $\Delta t_{HF}$ von den später im Zusammenhang mit der Erläuterung der Erfassungswerte E definierten Zeitschritten $\Delta t_E$ der Größenordnung von 100 Mikrosekunden.) Für einen gegebenen Zeitindex bzw. Abtastindex n und den zugehörigen Zeitpunkten $t_{HF}(n)$ nach Anregung des Schwingkreises kann die Spannung $U_{HF}(t_{HF}(n))$ abgetastet und beispielsweise in einem sogenannten Sample-and-Hold-Glied gespeichert werden, an dessen Ausgang das im Folgenden betrachtete Spannungssignal U(n) anliegt.

Zur Bestimmung des Spannungssignals U(n) kann eine einzelne Abtastung vor= genommen werden. Alternativ ist es möglich, den Schwingkreis wiederholt anzuregen, beispielsweise mit Wiederholfrequenzen im MHz-Bereich und eine Mittelung über die nach dem Sample-and-Hold-Glied jeweilig anliegenden Spannungssignals U(n) durchzuführen. Dieses Vorgehen ist zur Rauschbestimmung insbesondere dann vorteilhaft, wenn zur Erfassung eines einzelnen Spannungssignalwertes U(n) bzw. für einen Einzelmesswert E ein ausreichend langes Zeitintervall $\Delta t_E$ zur Verfügung steht.

Derartige Abtastschaltungen an sich sind beispielsweise von Oszilloskopen bekannt. Die Abtastindizes n können beispielsweise durch eine Digitalelektronik vorgewählt werden. Fig. 1a zeigt eine Zeitrampe zum Abtastvorgang und Fig. 1b einen vergrößerten Ausschnitt daraus mit Stufen m.

Wird die Messung des Spannungssignals U(n) beim Vorliegen gepulster Störungen ausgeführt, so sind die zugehörigen Einzelmesswerte E und damit auch eine daraus ermittelte Messgröße M potentiell verfälscht.

Im vorliegenden Beispiel der Abtastindex n, in Zeitabständen $\Delta t_E$ der Größenordnung von z.B. 100 Mikrosekunden jeweils um 1 erhöht werden, bis ein Maximalwert N erreicht ist. War der Zählindex n zum Zeitpunkt t=0 gleich Null, so erhält man für n die Zeitabhängigkeit

$$n(t) \ = \ n \ \times \ \Delta t_E$$

und somit für das abgetastete Messsignal U(n) =U(n(t)) ein zeitlich variierendes Signal U(t), welches der Veränderung der Abtastindizes n folgt (vgl. Fig. 1). Die Konsequenz ist, dass ein ursprünglich im Höchfrequenzbereich vorliegendes Messsignal $U_{HF'}$ welches im Beispiel das Abklingverhalten eines Schwingkreises beschreibt, durch synchrone Abtastung sequentiell auf ein Messsignal im Tonfrequenzbereich U(n(t)) abgebildet werden kann.

Es ist denkbar, dass für die für das Ortungsgerät gewünschte Aussage bereits ein einzelner Messwert E genügt, beispielsweise ein Spannungssignal U(m) für einen festen, vorgegebenen Index m (in Ördinatenrichtung). Ferner ist denkbar, dass Einzelmesswerte E in anderer Weise, beispielsweise durch Frequenzumsetzung, gewonnen werden.

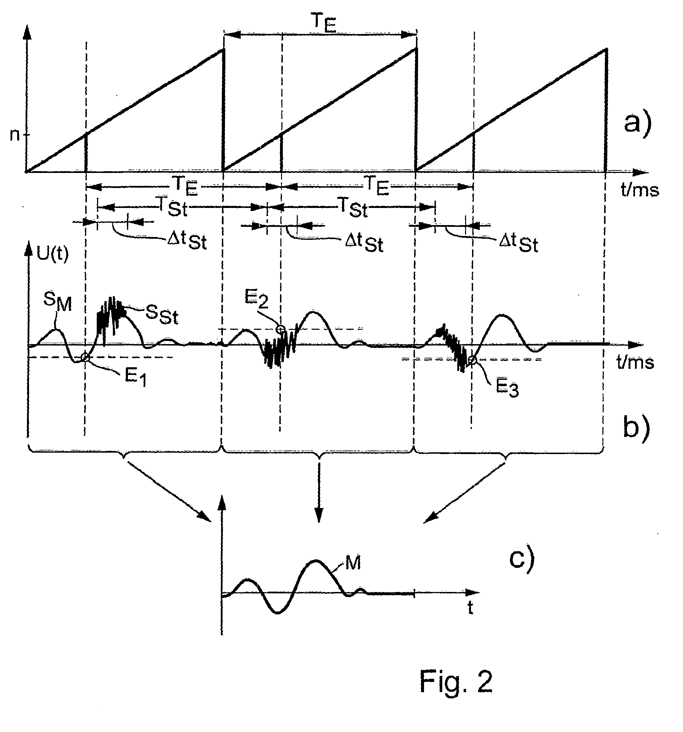

Im Ausführungsbeispiel ist es möglich, die Messung der potentiell gestörten Größe U(n) beliebig oft zu wiederholen. In dem in Fig. 2 skizzierten Beispiel erfolgt für einen gegebenen Index m die Messung von U(m) periodisch, jeweils mit einem Zeitabstand $T_E$.

Der Einfluss einer gepulsten Störquelle auf die einzelnen Messungen von U(m) ist in Fig. 2b dargestellt. Die einzelnen zum Index m gehörigen Einzelmesswerte sind dabei mit E1, E2 und E3 bezeichnet. Während dreier Zeitfenster der jeweiligen Länge bzw. Störpulsdauer $\Delta t_{ST}$ sind die gemessenen Signale U(n) mit einer Störung überlagert. Im dargestellten Verlauf von U(n(t)) bzw. U(t) (Fig. 2b) kann diese Störung durch starkes Rauschen erkannt werden. In dem in Fig. 2b gezeigten Fall wiederholen sich diese Störungen jeweils periodisch mit einem Zeitabstand bzw. Störpulsabstand $T_{ST}$. Die Eigenschaft einer festen Störpulsdauer $\Delta t_{St}$ und einer festen Störwiederholrate mit dem Störpulsabstand $T_{St}$ sind dabei charakteristisch für verschiedene Mobilfunkanwendungen, welche nach dem sogenannten TDMA (Time Division Multiple Access)-Verfahren arbeiten und in periodischen Intervallen (Frames) für kurze Zeit (Timeslotes) Störimpulse mit einem periodischen Impulsabstand generieren. Man erkennt aus Fig. 2b, dass von den drei aufeinander folgenden Messungen von U(m) nur der zweite Einzelmesswert E2 durch eine Störung verfälscht wird. Die Dauer des Störpulses $\Delta t_{ST}$ ist dabei deutlich länger als die Dauer $\Delta t_E$, welche zum Erfassen des Einzelmesswertes E zur Verfügung steht.

Im Folgenden soll von den Details der Gewinnung der Messsignale $S_M$ abstrahiert werden, da diese für das Verfahrensprinzip zur Entstörung nicht relevant sind. Wesentlich ist, dass potentiell störbehaftete Einzelmesswerte E eines Messsignals $S_M$ erfasst werden, und die Zeitabstände $T_E$ zwischen diesen Einzelmesswerten E geeignet gewählt werden.

Wesentlich ist vorliegend auch, dass der Einzelmesswert E, wie aus Fig. 2 ersichtlich, insbesondere durch ein Störsignal $S_{St}$ einer gepulsten Störquelle durch Einwirkung auf das aufgenommene Messsignal $S_M$ am Eingang des Messsystems überlagert sein kann, so dass der Einzelmesswert E, in Fig. 2 z.B. der zweite Einzelmesswert $E_2$, erheblich verfälscht ist. Derartige Störquellen resultieren insbesondere aus verschiedenen Mobilfunkanwendungen, z.B. nach dem DECT-Standard, aus dem GSM-Netz oder Bluetooth, die nach dem sogenannten TDMA (Time Division Multiple Access)-Verfahren arbeiten und in periodischen Intervallen (Frames) für kurze Zeit (Timeslots)Störimpulse mit einem periodischen Impulsabstand $T_{St}$ abstrahlen. Die Dauer des Störpulses $\Delta t_{St}$ ist dabei deutlich länger als die Erfassungsdauer $\Delta t_E$ des Einzelmesswertes E, so dass die für die Herleitung des Einzelmesswertes E verwendeten Signale im Rauschen des Störsignals $S_{St}$ untergehen.

Wie aus Fig. 2 weiter ersichtlich, werden vorliegend zur Beseitigung von durch derartige impulsförmige Störsignale verursachten Störungen noch mindestens zwei weitere Messungen zum Erfassen der Einzelmesswerte E an den entsprechenden Zeitpositionen des aufgenommenen Messsignals $S_M$ durchgeführt, wobei die Zeitabstände $T_E$ der weiteren Erfassungen so gewählt werden, dass sie sich von dem Störpulsabstand $T_{St}$ unterscheiden.

Dadurch ist sichergestellt, dass z.B. bei drei Erfassungen von Einzelmesswerten E mindestens zwei Einzelmesswerte E, d.h. jedenfalls mehr als die Hälfte der Einzelmesswerte E, in die Intervalle des Störsignals $S_{St}$ fallen und dadurch nicht von Störimpulsen überlagert sind.

Im weiteren Verfahren wird nun eine geeignete Auswertung der Einzelmesswerte E vorgenommen, beispielsweise eine Unterscheidung getroffen, welcher oder welche Einzelmesswert(e) E sich von den anderen signifikant unterscheidet/unterscheiden. Bei der weiteren Auswertung wird bzw. werden dann diese(r) Einzelwert(e) E verworfen und aus den anderen Einzelmesswerten E, die in ihrer Anzahl überwiegen, der Mittelwert gebildet und aus dem gemittelten Einzelmesswert die störbefreite Messgröße M gewonnen (vgl. Fig. 2c). Eine vorteilhafte alternative Auswertung besteht darin, dass aus den Einzelmesswerten E der Median gebildet wird, woraus sich eine sehr einfache und dabei zuverlässige Gewinnung der Messgröße M ergibt.

Vorzugsweise wird der Zeitabstand zum Erfassen der Einzelmesswerte E mit einer festen Periodendauer $T_E$ gewählt und geeignet an die Intervalle bzw. Lücken des Störsignals $S_{St}$ angepasst. Hierbei ergeben sich verschiedene mögliche Zeitfenster, die vorteilhaft auch so gewählt werden können, dass die beschriebene Störbeseitigung bei verschiedenen gängigen gepulsten Störquellen mit unterschiedlicher Störpulsdauer $\Delta t_{St}$ und/oder unterschiedlichem Störpulsabstand $T_{St}$ wirksam ist. Für eine Störung durch DECT- und GSM-Mobiltelefone ist eine geeignete Periodendauer $T_E$ zum Erfassen der Einzelmesswerte E (Zeitfenster) zwischen 10417 µs und 11249 µs, wobei die Mitte dieses Zeitfensters bei 10833 µs liegt. Weitere Zeitfenster ergeben sich aus der nachfolgenden Tabelle:

| Dienst | Mögliche Messintervalle | | |
|---|---|---|---|
| GSM | 577 µs | - | 2.01 ms |
| | 2.59 ms | - | 4.04 ms |
| | 5.19 ms | - | 6.63 ms |
| | 9.807 ms | - | 11.249 ms |
| DECT | 417 µs | - | 4.79 ms |
| | 5.21 ms | - | 9.58 ms |
| | 10.42ms | - | 14.79 ms |
| Bluetooth HV2 | 625 µs | - | 938 ms |
| | 1.56 ms | - | 1.87 ms |
| | 3.13 ms | - | 3.43ms |
| | 4.07 ms | - | 4.37 ms |
| | 5.63 ms | - | 5.94 ms |
| Bluetooth HV3 | 625 µs | - | 1.56ms |
| | 2.19 ms | - | 3.12 ms |
| | 4.37 ms | - | 5.31 ms |

Eine weitere Möglichkeit ist die adaptive Anpassung der Zeitabstände $T_E$ (Messintervalle) zum Erfassen der Einzelmesswerte E. Dazu müssten der Störpulsabstand $T_{St}$ und die Störpulsdauer $\Delta t_{St}$ beispielsweise mittels entsprechender Programmierung des Messsystems bestimmt werden. Diese Vorgehensweise ist zwar flexibel, jedoch relativ aufwändig.

Eine weitere ähnliche Möglichkeit zur Störbeseitigung wie die vorstehend beschriebene besteht darin, dass zunächst festgestellt wird, ob ein Störsignal vorhanden ist, und dass das Messsignal $S_M$ bzw. die Einzelmesswerte E dann aufgenommen werden, wenn ein Störsignal nicht vorhanden ist.

Zum Feststellen, ob eine Störung durch eine pulsartig abstrahlende Störquelle vorliegt, besteht eine vorteilhafte Möglichkeit darin, dass die erste oder eine höhere Ableitung des empfangenen Messsignals $S_M$ oder einer geeigneten Umrechnungsgröße desselben, insbesondere der Quadratsumme der Amplituden, über der Zeit berechnet wird. Störquellen der vorstehend angegebenen Art ergeben Änderungen in dem Messsignal mit relativ steilen Flanken, die gegenüber den relativ flachen Änderungen des Messsignals, wie sie beispielsweise durch eine relative Positionsänderung zwischen Messobjekt und Messgerät bei einem Absuchvorgang entstehen, durch die Ableitung zuverlässig detektiert werden können. Mit einer derartigen vorgeschalteten Erkennung kann der Betrieb einer Störquelle sicher erkannt werden, so dass diese Information bei der Auswertung mit berücksichtigt werden kann.

**Patentansprüche**

1. Verfahren zur Störbefreiung von Messsignalen ($S_M$), die von gepulsten Störsignalen ($S_{SI}$) mit einem bekannten oder bestimmbaren Störpulsabstand ($T_{St}$) verfälscht sind, wobei die Erfassungsdauer ($\Delta t_E$) eines Einzelmesswertes (E) kleiner als eine Störpulsdauer ($\Delta t_{St}$) und mehrere Einzelmesswerte (E) in frei wählbaren Zeitabständen ($T_E$) des Messsignals ($S_M$) erfasst werden, **dadurch gekennzeichnet, dass** mindestens drei aufeinander folgende Einzelmesswerte (E) mit Zeitabständen ($T_E$) erfasst werden, die sich von dem Störpulsabstand ($T_{St}$) unterscheiden, und dass mit den mindestens drei Einzelmesswerten (E) eine störbefreite Messgröße (M) ermittelt wird.

2. Verfahren nach Anspruch 1, **dadurch gekennzeichnet, dass** die Zeitabstände ($T_E$) konstant sind und die Einzelmesswerte mit einer festen Periodendauer erfasst werden.

3. Verfahren nach Anspruch 1 oder 2, **dadurch gekennzeichnet, dass** die Messgröße (M) auf der Grundlage des Medians bestimmt wird.

4. Verfahren nach Anspruch 1 oder 2, **dadurch gekennzeichnet, dass** festgestellt wird, welcher oder welche Einzelmesswert(e) (E) sich von den anderen, mehr als die Hälfte darstellenden Einzelmesswerten am meisten unterscheidet/unterscheiden, und dass die Messgröße (M) mit dem Mittelwert der anderen Einzelmesswerte bestimmt wird.

5. Verfahren nach einem der Ansprüche 2 bis 4, **dadurch gekennzeichnet, dass** die Periodendauer ($T_E$) so gewählt ist, dass das Messsignal ($S_M$) von mindestens zwei verschiedenen Störsignalen ($s_{St}$) mit unterschiedlichem Störpulsabstand ($T_{St}$) befreit wird.

6. Verfahren nach einem der vorhergehenden Ansprüche, **dadurch gekennzeichnet, dass** zum Unterscheiden verfälschter und unverfälschter Messsignale ($S_M$) die erste oder eine höhere Ableitung einer Funktion der Amplituden des Messsignals ($S_M$) über der Zeit berechnet wird.

**Claims**

1. Method for removing interference from measurement signals ($S_M$) which are distorted by pulsed interference signals ($S_{St}$) having an interference pulse interval ($T_{St}$) which is known or can be determined, the detection period ($\Delta t_E$) for an individual measured value (E) being shorter than an interference pulse duration ($\Delta t_{St}$) and a plurality of individual measured values (E) being detected at freely selectable intervals ($T_E$) of the measurement signal ($S_M$), **characterized in that** at least three successive individual measured values (E) are detected at intervals ($T_E$) which differ from the interference pulse interval ($T_{St}$), and **in that** the at least three individual measured values (E) are used to determine a measurement variable (M) from which the interference has been removed.

2. Method according to Claim 1, **characterized in that** the intervals ($T_E$) are constant and the individual measured values are detected with a fixed period duration.

3. Method according to Claim 1 or 2, **characterized in that** the measurement variable (M) is determined on the basis of the median.

4. Method according to Claim 1 or 2, **characterized in that that**/those individual measured value(s) (E) which differs(s) most from the other individual measured values which represent more than half of the measured values is/are determined, and **in that** the measurement variable (M) is determined using the mean value of the other individual measured values.

5. Method according to one of Claims 2 to 4, **characterized in that** the period duration ($T_E$) is selected in such a manner that at least two different interference signals ($S_{St}$) with a different interference pulse interval ($T_{St}$) are removed from the measurement signal ($S_M$).

6. Method according to one of the preceding claims, **characterized in that** the first derivative or a higher derivative of a function of the amplitudes of the measurement signal ($S_M$) over time is calculated for the purpose of distinguishing between distorted and undistorted measurement signals ($S_M$).

**Revendications**

1.  Procédé de déparasitage de signaux de mesure (s$_M$) faussés par des signaux parasites pulsés (Sst) ayant un intervalle d'impulsion parasite (Tst) connu ou susceptible d'être déterminé,

    la durée de saisie ($\Delta$t$_E$) d'une seule valeur de mesure (E) étant inférieure à la durée d'impulsion parasite ($\Delta$t$_{St}$) et plusieurs valeurs de mesure distinctes (E) étant saisies à des intervalles de temps (T$_E$) choisis librement du signal de mesure (S$_M$),

    **caractérisé en ce qu'**

    on saisit au moins trois valeurs de mesure distinctes (E) qui se succèdent à des intervalles de temps (T$_E$) différents des intervalles des impulsions parasites (Tst) et à l'aide d'au moins ces trois valeurs de mesure, on forme une grandeur de mesure déparasitée (M).

2.  Procédé selon la revendication 1,

    **caractérisé en ce que**

    les intervalles de temps (T$_E$) sont constants et les valeurs de mesure séparées sont saisies selon une période fixe.

3.  Procédé selon l'une quelconque des revendications 1 ou 2,

    **caractérisé en ce qu'**

    on détermine les grandeurs de mesure (M) en se fondant sur la médiane.

4.  Procédé selon l'une quelconque des revendications 1 ou 2,

    **caractérisé en ce qu'**

    on détermine la ou les valeurs séparées (E) qui se distinguent le plus de plus de la moitié des valeurs de mesure séparées, représentées, et

    on détermine les grandeurs de mesure (M) avec la valeur moyenne des autres valeurs de mesure séparées.

5.  Procédé selon l'une quelconque des revendications 2 à 4,

    **caractérisé en ce qu'**

    on choisit la période (T$_E$) pour que le signal de mesure (S$_M$) soit libéré d'au moins deux signaux parasites différents (Sst) avec les intervalles d'impulsion parasitée différents (T$_{St}$).

6.  Procédé selon l'une quelconque des revendications précédentes,

    **caractérisé en ce que**

    pour distinguer des signaux de mesure faussés des signaux non faussés (S$_M$) on calcule le premier ordre d'une dérivée supérieure d'une fonction des amplitudes du signal de mesure (S$_M$) en fonction du temps.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0214847 A1
- DE 19915016 C2

- DE 3905735 A1